(19)

Europäisches
Patentamt
European
Patent Office
Office européen
des brevets

(11) **EP 2 117 049 A1**

(12) **EUROPEAN PATENT APPLICATION**
published in accordance with Art. 153(4) EPC

(43) Date of publication:
**11.11.2009 Bulletin 2009/46**

(21) Application number: **08711807.1**

(22) Date of filing: **22.02.2008**

(51) Int Cl.:
**H01L 31/04** (2006.01)  **C08K 5/14** (2006.01)
**C08L 23/08** (2006.01)

(86) International application number:
**PCT/JP2008/053033**

(87) International publication number:
**WO 2008/102863 (28.08.2008 Gazette 2008/35)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **23.02.2007 JP 2007043531**

(71) Applicant: **Bridgestone Corporation**
**Tokyo 104-0031 (JP)**

(72) Inventors:
• **TOMIYAMA, Makiko**
**Yokohama-shi**
**Kanagawa 244-8510 (JP)**
• **INOUE, Yoshihiko**
**Yokohama-shi**
**Kanagawa 244-8510 (JP)**

(74) Representative: **Whalley, Kevin**
**Marks & Clerk LLP**
**90 Long Acre**
**London WC2E 9RA (GB)**

(54) **SOLAR CELL SEALING FILM AND SOLAR CELL UTILIZING THE SAME**

(57)     An object of the present invention is to provide a solar cell sealing film which can suppress expansion of the solar cell. A solar cell sealing film including ethylene-vinyl acetate copolymer and a crosslinker is provided, wherein the crosslinker is an organic peroxide having an activation energy of 140 kJ/mol or more, and a value obtained by multiplying the content of the organic peroxide based on 100 parts by weight of the ethylene-vinyl acetate copolymer by the theoretical active oxygen content of the organic peroxide is in the range of 3 to 18.

EP 2 117 049 A1

**Description**

Background of the Invention

Field of the invention

The present invention relates to a sealing film for a solar cell containing therein ethylene-vinyl acetate copolymer as a main component, and in particular a sealing film for a solar cell by which expansion of the solar cell can be suppressed.

Description of the Related Art

In recent years, a solar cell, in which sunlight is directly converted to electrical energy is widely used, so as to provide for the effective use of natural resources and prevent environmental pollution. Further developments are being made with respect to solar cells.

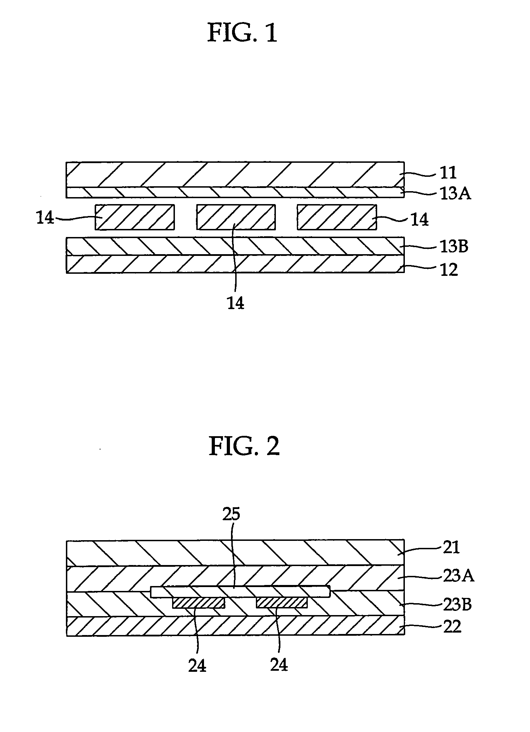

Generally speaking, a solar cell includes a plurality of photovoltaic elements 14 such as silicon electricity generation elements provided between a transparent front side protection material 11 and a backside protection material 12 (backside covering member), as shown in Fig. 1. A front side sealing film 13A and a backside sealing film 13B are interposed, respectively, between the photovoltaic elements 14 and the front side protection material 11, and between the photovoltaic elements 14 and the backside protection material 12 for sealing the photovoltaic elements 14. Thus, a plurality of photovoltaic elements 14 are connected in series or in parallel with each other, and sealed by the front side sealing film 13A and the back side sealing film 13B. The sealing films also provide insulation properties.

In a conventional solar cell, a transparent substrate such as a glass substrate is used as a transparent front side protection material in order to effectively condense the incident light on the solar cell into the photovoltaic elements. On the other hand, a plastic film such as polyethylene terephthalate (PET) or a plastic film having a silver-deposited layer thereon is used as the backside protection material in order to prevent water from entering into the solar cell.

The front side and the backside sealing films are expected to prevent a foreign substance or water/moisture from entering the solar cell, and maintain the insulating properties of the solar cell and interelectrodes. From such point of view, a film made of ethylene-polar monomer copolymer such as ethylene-vinyl acetate copolymer (EVA) or ethylene-ethyl acrylate copolymer (EEA) is used as the front side sealing film or the backside sealing film. Among the ethylene-polar monomer copolymers, EVA film is preferably used because of low price and excellent transparency.

Generally speaking, a solar cell prepared by using a sealing film containing, for instance, EVA is manufactured as follows. An EVA composition comprising EVA and a crosslinker is formed into a sealing film as the front side and back side sealing films. Thereafter, the transparent front side protection material, front side sealing film, photovoltaic elements, back side sealing film and backside protection material are successively laminated in this order. Then, heat and pressure are applied to the laminate so that the sealing films are cured by crosslinking to prepare a solar cell as an integral body.

In the conventional solar cell sealing film, as discussed above, a crosslinker in addition to ethylene-polar monomer copolymer is used for increasing the crosslink density of the sealing film, and hence for improving the transparency, flexibility and moldability thereof. As a method for activating the crosslinker, a thermal decomposition method, a redox decomposition method and an ion decomposition method are known. The thermal decomposition method is generally used (Patent Document 1).

Patent Document 1: JP-A 2000-183385

Disclosure of the Invention

Problem to be solved by the Invention

A broad range of research and development has been conducted on solar cells. To increase the use, it is required for the solar cell to maintain electricity generating properties at a high level and external design properties for a long period, e.g., for a few decades, even under extremely severe natural environmental conditions such as outdoor high temperature and humidity and exposure to wind, rain and other weather conditions. In the conventional solar cell, however, expansion of the solar cell occurs over time. As a result, the electricity generating properties and the external design properties of the solar cell sometimes cannot be maintained.

The inventors of the present invention have found, based on their study, that the above-discussed expansion of the solar cell is caused by the oxidative deterioration of EVA contained in the sealing film. For preparing a sealing film by use of EVA, a crosslinker such as organic peroxide is used for increasing the crosslink density of the monomer. Namely, the use of the organic peroxide helps to improve the cross link density of EVA which helps to improve the light resistance of the sealing film. On the other hand, the use of the organic peroxide makes to produce unstable contents including reaction residue and unreacted materials in the sealing film. When the sealing film including the unstable contents is exposed to light including UV light or subjected to heating for a long time, the unstable contents easily decompose and radicals are produced. Once a radical is generated, new radicals further generate by chain reaction, which results in the oxidative deterioration of EVA. Accordingly, a decomposition gas is produced in the cell, remains at the interface between the sealing films and the photovoltaic elements, and caused the solar cell to expand.

To provide a solar cell with an excellent durability, which is capable of maintaining a high level of electricity generation and external design properties for a long time, it is effective to suppress the decomposition gas production because of the oxidative deterioration of EVA in the solar cell sealing film.

It is therefore an object of the present invention to provide a solar cell sealing film with which expansion of the solar cell can be suppressed.

Another object of the present invention is to provide a solar cell incorporating the solar cell sealing film of the invention.

Effect of the Invention

The inventors of the present invention made various studies regarding the above-discussed viewpoints. Consequently, the inventors found that it is possible to provide a solar cell sealing film in which the production of the decomposed gas is reduced. Hence, expansion of the solar cell is suppressed even with the application of light (e.g., UV light) and heat, without decreasing the crosslink density of ethylene-vinyl acetate copolymer. The sealing film is obtained by blending therein a predetermined amount of an organic peroxide, as a crosslinker, having a predetermined activation energy.

Namely, an object of the present invention was achieved by a solar cell sealing film comprising ethylene-vinyl acetate copolymer and a crosslinker, the cross linker being an organic peroxide having an activation energy of 140 kJ/mol or more, and a value obtained by multiplying the content of the organic peroxide based on 100 parts by weight of ethylene-vinyl acetate copolymer by theoretical active oxygen content being in the range of 3 to 18.

An exemplary embodiment of the solar cell sealing film of the present invention will now be explained.

(1) The crosslinker is a dialkyl peroxide-based organic peroxide.

(2) The content of vinyl acetate based on 100 parts by weight of ethylene-vinyl acetate is in the range of 20 to 35 parts by weight.

(3) The crosslinker in an amount of 0.1 to 5.0 parts by weight is included based on 100 parts by weight of ethylene-vinyl acetate.

Brief Description of the Drawings

[Fig. 1] Fig. 1 is a diagram for explaining a structure of a typical solar cell.
[Fig. 2] Fig. 2 is a cross-section of a module for a foam test, prepared in the example discussed below.

Explanation of reference numerals

11:     transparent front side protection material
12:     backside protection material
13A:    front side sealing film
13B:    backside sealing film
14:     photovoltaic element
21:     glass substrate
22:     back sheet
23A:    front side sealing film
23B:    backside sealing film
24:     polyethylene terephthalate film
25:     aluminum substrate

Best Mode for carrying out the Invention

A solar cell sealing film of the present invention includes an organic peroxide having an activation energy of 140 kJ/mol or more as a crosslinker, in addition to ethylene-vinyl acetate copolymer. The organic peroxide with above-mentioned activation energy is not easily decomposed even when energy such as ultraviolet light or heat is applied to the solar cell sealing film containing therein the peroxide when the solar cell is in use. Therefore, the production of peroxy radical, which is a cause of the oxidative deterioration of ethylene-vinyl acetate copolymer, is suppressed. Accordingly, even when energy such as UV light or heat is applied to the solar cell wherein a sealing film is used, the sealing film including reaction residue of the organic peroxide or unreacted materials thereof, it is possible to restrict the generation of the decomposition gas resulted from the oxidative deterioration of ethylene-vinyl acetate copolymer.

Further, it is possible in the solar cell sealing film of the present invention to perform a crosslinking reaction of ethylene-vinyl acetate copolymer to have a sufficient density by the use of the organic peroxide which is not easily decomposed by the irradiation of energy thereto. This is achieved by blending the organic peroxide to the ethylene-vinyl acetate copolymer so that a value obtained by multiplying the content of the organic peroxide based on 100 parts by weight of ethylene vinyl acetate copolymer by the theoretical active oxygen content becomes 3 to 18.

Accordingly, it is possible in the present invention to provide a solar cell sealing film which can suppress expansion of the solar cell without decreasing properties such transparency, flexibility and moldability.

The solar cell sealing film of the present invention will now be explained more in detail.

<Crosslinker>

The activation energy of the crosslinker used for the sealing film of the present invention is 140kJ/mol or more, preferably 150 kJ/mol or more, more preferably 150 to 180 kJ/mol, and particularly preferably 150 to 175 kJ/mol.

The activation energy of the crosslinker for use in the present invention is shown by a value defined by the following formula (I):

[Formula 1]

$$k_c t = A \mathrm{Exp}\left[-\frac{\Delta E}{kT}\right] \qquad (1)$$

(wherein, kc is decomposition rate constant, A is frequency factor, E is activation energy, k is Bolzmann factor, and T is a temperature [K].)

Further, the solar cell sealing film of the present invention includes the organic peroxide so that the value (Cp $\times$ Aw) obtained by multiplying the content (Cp) of the organic peroxide based on 100 parts by weight of ethylene-vinyl acetate copolymer by the theoretical active oxygen content (Aw) of the organic peroxide is in the range of 3 to 18, preferably in the range of 3 to 15, and particularly preferably in the range of 3 to 10. When the value obtained by multiplying Cp by Aw is less than 3, there is a possibility that the crosslinkage of ethylene-vinyl acetate copolymer does not progress to obtain a sufficient density. When the value exceeds 18, it is possible that free radicals generate by the irradiation of energy such as ultraviolet light or heat to the solar cell.

In the present invention, the theoretical active oxygen content of the organic peroxide is a value obtained by the following formula (2):

[Formula 2]

$$\text{Theoretical active oxygen content}(\%) = \{(No \times 16)/Mw\} \times 100 \qquad (2)$$

No: Number of -O-O- bond in the organic peroxide
Mw: Molecular weight of organic peroxide

It is possible to use a conventionally known crosslinker as the crosslinker for use in the sealing film of the invention, without any special restriction as long as the crosslinker has an activation energy of 140 kJ/mol or more. Preferred examples of the crosslinker include the following materials. The activation energy of the crosslinker is described in the bracket.

2,2-di(4,4-di-(t-butylperoxy)cyclohexyl)propane (141.2 kJ/mol), t-butylperoxyisopropyl monocarbonate (142.1 kJ/mol), t-hexyl peroxybenzoate (141.0 kJ/mol), 2,5-di-methyl-2,5-di(benzoylperoxy)hexane (146.2 kJ/mol), t-butyl peroxyacetate (148.9 kJ/mol), 2,2-di-(t-butylperoxy)butane (152.4 kJ/mol), t-butyl peroxybenzoate (141.3 kJ/mol), di(2-t-butylperoxyisopropyl)benzene (166.3 kJ/mol), dicumyl peroxide (158.0 kJ/mol), di-t-hexyl peroxide (154.5 kJ/mol), 2,5-dimethyl-2,5-di(t-butylperoxy) hexane (152.0 kJ/mol), t-butylcumyl peroxide (173.1 kJ/mol), di-t-butyl peroxide (155.8 kJ/mol), p-menthan hydroperoxide (141.0 kJ/mol) and 2,5-dimethyl-2,5-di(t-butylperoxy)hexyn-3 (151.3 kJ/mol). These cross linkers can be used alone or as a combination of two or more.

Of these, it is preferable to use dialkyl peroxide-based organic peroxides as the crosslinkers. The crosslinkers of this type hardly produce a decomposition gas, and help to satisfactorily increase the crosslink density of ethylene-vinyl acetate. Thus, the durability of the solar cell sealing film can be further improved.

Examples of the dialkyl peroxide-based organic peroxide include di(2-t-butylperoxyisopropyl)benzene, dicumyl peroxide, di-t-hexylperoxide, 2,5-dimethyl-2,5-di(t-butylperoxy)hexane, t-butyl cumyl peroxide, and di-t-butyl peroxide.

<Ethylene-vinyl acetate copolymer>

The sealing film of the present invention comprises ethylene-vinyl acetate copolymer, in addition to the above-mentioned crosslinker. It is possible to add, if necessary, polyvinyl acetal resins such as polyvinyl formal, polyvinyl butyral (PVB resin) and modified PVB, and polyvinyl chloride for the combined use with ethylene-vinyl acetate copolymer. However, the single use of ethylene-vinyl acetate is preferred.

It is preferable that the content of vinyl acetate in the ethylene-vinyl acetate copolymer is in the range of 20 to 35 parts by weight, and more preferably 24 to 28 parts by weight, based on 100 parts of the ethylene-vinyl acetate. When the content of vinyl acetate is less than 20 parts by weight, it is possible that the resin crosslinked/cured at a high temperature does not have a satisfactory transparency. On the other hand, when the content of vinyl acetate is more than 35 parts by weight, it is possible that a decomposition gas is easily generated when energy such as ultraviolet light or heat is applied to the sealing film.

<Crosslinking auxiliary>

Moreover, the solar cell sealing film of the invention can include crosslinking auxiliary, if necessary. The crosslinking auxiliary helps to increase of the crosslink density of ethylene-vinyl acetate copolymer.

Examples of the crosslinking auxiliary (a compound having a radical polymerizable group as a functional group) include trifunctional crosslinking auxiliaries such as triallyl cyanurate and triallyl isocyanurate, and monofunctional or bifunctional crosslinking auxiliaries such as (meth)acrylic esters (e.g., NK ester, etc.). Of these, triallyl cyanurate is preferably used.

It is preferable that the content of the crosslinking auxiliary is in the range of 0.1 to 5.0 parts by weight, more preferably 0.1 to 2.5 parts by weight based on 100 parts by weight of ethylene-vinyl acetate copolymer.

<Adhesion improver>

It is preferable that the solar cell sealing film of the present invention has excellent adhesion properties in view of sealing properties within the solar cell. Accordingly, it is preferable for the sealing film to further include an adhesion improver.

Silane-coupling agents can be used as the adhesion improver, whereby a solar cell sealing film having excellent adhesion can be obtained. Examples of the silane coupling agent include γ-chloropropylmethoxy-silane, vinylethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane and N-β-(aminoethyl)-γ-aminopropyltrimethoxysilane. These silane coupling agents can be used alone, or in combination of two or more. Especially preferred is γ-methacryloxypropyltrimethoxysilane.

The content of silane coupling agent is preferably in the range of 0.1 to 1.0 part by weight, and particularly 0.3 to 0.8 parts by weight based on 100 parts by weight of ethylene-vinyl acetate copolymer.

<Others>

The solar cell sealing film of the present invention may further contain various additives such as plasticizer, acryloxy group-containing compound, methacryloxy group-containing compound and/or epoxy group-containing compound, if necessary, for improving or adjusting various properties of the film (e.g., mechanical strength, optical characteristics such as transparency, heat resistance, light resistance, crosslinking rate).

Polybasic acid esters and polyvalent alcohol esters can be generally used as the plasticizer although there is no particular restriction to the plasticizer. Examples of the plasticizer include dioctyl phthalate, dihexyl adipate, triethylene glycol-di-2-ethyl butyrate, butyl sebacate, tetraethylene glycol diheptanoate and triethylene glycol dipelargonate. The plasticizers can be used alone, or in combination of two or more. It is preferable that the content of the plasticizer is not more than 5 parts by weight based on 100 parts by weight of ethylene-vinyl acetate copolymer.

Generally speaking, examples of the acryloxy group-containing compound and methacryloxy group-containing compound include derivatives of acrylic acid or methacrylic acid, such as esters or amides of acrylic acid or methacrylic acid. Examples of the ester residue include linear alkyl group (e.g., methyl, ethyl, dodecyl, stearyl and lauryl), cyclohexyl group, tetrahydrofurfuryl group, aminoethyl group, 2-hydroxyethyl group, 3-hydroxypropyl group, and 3-chloro-2-hydroxypropyl group. Moreover, examples of the amide include diacetone acryl amide. Further, the esters include esters of acrylic acid or methacrylic acid with polyhydric alcohol such as ethylene glycol, triethylene glycol, polypropylene glycol, polyethylene glycol, trimethylol propane or pentaerythritol.

Examples of the epoxy group containing compound include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol(ethyleneoxy)$_5$glycidyl ether, p-t-butylphenyl glycidyl ether, diglycidyl adipate, diglycidyl phthalate, glycidyl methacrylate and butyl glycidyl ether.

Each of the acryloxy group-containing compound, methacryloxy group-containing compound and epoxy group-containing compound is, in general, contained in an amount in the range of 0.5 to 5.0 parts by weight, particularly in the range of 1.0 to 4.0 parts by weight based on 100 parts by weight of ethylene-vinyl acetate copolymer.

The solar cell sealing film may further comprise an ultraviolet absorbent, a photostabilizer and an antioxidant.

When the solar cell sealing film contains the ultraviolet absorbent, EVA is prevented from deteriorating by the effect of light irradiation thereto, and yellowing of the solar cell sealing film. Examples of the ultraviolet absorbent include benzophenone ultraviolet absorbents such as 2-hydroxy-4-methoxybenzophenone, 2-hydroxy-4-n-dodecyloxy-benzophenone, 2,4-dihydroxybenzophenone, 2,2'-dihydroxy-4-methoxybenzophenone, and 2-hydroxy-4-n-octoxybenzophenone, though there is no special restriction to the absorbent. The content of the benzophenone ultraviolet absorbent is preferably in the range of 0.01 to 5 parts by weight based on 100 parts by weight of ethylene-vinyl acetate copolymer.

By including the photostabilizer to the solar cell sealing film, it is also possible to prevent the ethylene-vinyl acetate copolymer from deteriorating due to light irradiation and from yellowing of the solar cell sealing film. A so-called hindered amine photostabilizer can be used as the photostabilizer. Examples of the photostabilizer include LA-52, LA-57, LA-62, LA-63, LA-63p, LA-67 and LA-68 (each manufactured by ADEKA Co., Ltd.), Tinuvin 744, Tinuvin 770, Tinuvin 765, Tinuvin 144, Tinuvin 622LD, and CHIMASSORB 944LD (each manufactured by Ciba Specialty Chemicals Co., Ltd.), and UV-3034 (manufactured by B. F. Goodrich). The photostabilizers can be used alone, or in combination of two or more. The content of the photostabilizer is preferably in the range of 0.01 to 5 parts by weight based on 100 parts by weight of ethylene-vinyl acetate copolymer.

Examples of the antioxidants include hindered phenol-type antioxidants such as N,N'-hexan-1,6-diyl-bis[3-(3,5-di-tert-butyl-4-hydroxyphenyl) propionamide], phosphorus-type heat stabilizers, lactone-type heat stabilizers, vitamin E-type heat stabilizers and sulfur-type heat stabilizers.

The formation of the solar cell sealing film can be carried out according to known processes. The solar cell sealing film can be formed, for example, by forming the composition by using extrusion molding or calendaring. Alternatively, the solar cell sealing film can be formed also by dissolving the composition in a solvent to form a solution, applying the solution to an appropriate support by means of an appropriate coater, and then drying it to form a coated layer. The heating temperature at the film-formation is preferably in the range of 50 to 90°C, in particular in the range of 40 to 80 °C. Thereafter, the solar cell sealing film is crosslinked or cured in accordance with a conventional method such as application of heat and pressure thereto, for using the film for sealing.

There is no restriction to the thickness of the solar cell sealing film. However, the thickness of the solar cell sealing film is generally in the range of 50 $\mu$m to 2 mm.

It is possible to restrict a decomposition gas to be generated in the course of the oxidative deterioration of ethylene-vinyl acetate copolymer in the solar cell sealing film of the invention, because the sealing film of the invention comprises therein an organic peroxide, as a crosslinker, which is not easily decomposed by energy irradiation thereto. Accordingly, expansion of the solar cell can be restricted in the solar cell sealing film of the invention even when energy such as UV light or heat is applied thereto. Namely, it is possible to maintain the electricity generating properties at a high level and the external design properties for a long time.

The structure of the solar cell incorporating the solar cell sealing film according to the invention is not particularly restricted. For example, the structure of the solar cell can be formed by a transparent front side protection material, a backside protection material, photovoltaic elements provided between the front side and the backside protection materials, and the solar cell sealing film interposed between the photovoltaic elements and the front side protection material and between the photovoltaic elements and the backside protection material. Thus, the photovoltaic elements are sealed by the sealing film of the invention. In the present invention, the "front side" corresponds to light-receiving side of the photovoltaic elements, whereas the "backside" corresponds to the reverse side with respect to the light-receiving side of the photovoltaic elements.

The solar cell is prepared by using the sealing film as shown in Fig. 1. More precisely, two sealing films 13A and 13B are provided between a transparent front side protection material 11 and a backside protection material 12, and photovoltaic elements 14 are provided between the sealing films 13A and 13B to configure a laminate. The laminate is heated in accordance with a conventional method so that the photovoltaic elements 14 are sealed.

By the heat application, the ethylene-vinyl acetate included in the surface sealing film and the backside sealing film is crosslinked. Therefore, the transparent front side protection material, the backside protection material, and photovoltaic elements are made integral with one another by the provision of the front side sealing film and the backside sealing film. Thus, the photovoltaic elements are sealed by the sealing film.

It is preferable that the heat application is carried out at a temperature in the range of 130 to 180°C, preferably in the range of 140 to 180°C, particularly in the range of 150 to 180°C for 5 to 60 minutes. As discussed above, the solar cell sealing film of the invention includes an organic peroxide which is not easily decomposed by irradiation of energy. Under heat and pressure conditions of the invention, it is possible to satisfactorily crosslink ethylene-vinyl acetate copolymer by use of the organic peroxide.

Prior to heat application, it is preferable to perform preliminary heat and pressure application to the previously described laminate by using e.g., a vacuum laminator. It is preferable that the preliminary heat and pressure application is carried out at a temperature in the range of 80 to 120°C, and a pressing pressure of about 0.1 to 1.5 kg/cm$^2$, for 5 to 15 minutes. Accordingly, the layers in the solar cell can be sufficiently adhered to each other.

It is typical to use a glass substrate such as silicate glass as the transparent front side protection material of the invention. The thickness of the glass substrate is generally in the range of 0.1 to 10 mm, preferably in the range of 0. 3 to 5 mm. It is preferable that the glass substrate is chemically or thermally tempered.

The backside protection material of the invention is generally a plastic film such as polyvinyl fluoride (PVF), polyethylene fluoride and PET. It is preferable that, in view of heat resistance and wet heat resistance, the back protection material is a laminate of a plastic film and a deposited film made of a metal such as silver or aluminum provided on the surface of the plastic film. Particularly preferred laminate is obtained by successively laminating a plastic film / metal deposited film / plastic film in this order.

The solar cell of the invention is characterized by the sealing film provided on the front side and the backside. Therefore, there is no particular restriction on members other than the sealing film (the other members), that is, transparent front side protection material, backside protection material, photovoltaic elements, and etc. As the other members, it is possible to use members having structures known in conventional solar cells.

EXAMPLE

The invention will now be illustrated in detail by the following Examples. The invention is not restricted to the following Examples.

[Example 1]

    (1) Ethylene-vinyl acetate copolymer (vinyl acetate content of 25 parts by weight): 100 parts by weight
    (2) Crosslinker, (2,5-dimethyl-2,5-di(benzoylperoxy)hexane): 0.6 parts by weight

An EVA resin composition having the above-mentioned formulation was subjected to calendering treatment at 80°C to prepare an EVA film (thickness: 500μm).

[Examples 2-5 and Comparison Examples 1-2]

The procedures in Example 1 were repeated except that the crosslinker was replaced by those shown in Table 1, to prepare EVA films.

(Evaluation of EVA films)

The generation of decomposition gas was evaluated, with respect to EVA films prepared in Examples 1 to 5 and Comparative Examples 1 and 2, in accordance with the following procedure.

Two sheet of EVA film is used as a front side sealing film 23A and a backside sealing film 23B. As shown in Fig. 2, a back sheet 22, backside sealing film 23B, polyethylene terephthalate film ("Lumirror" manufactured by Toray Industries, Inc.; thickness of 0.5 μm) 24, aluminum substrate (thickness of 0.5 mm) 25, front side sealing film 23A, and glass substrate (thickness of 3 mm) 21 were successively laminated in this order. The thus obtained laminate was subjected to press bonding at 90°C under a vacuum condition in a vacuum laminator for 2 minutes. Thereafter, heat and pressure were applied to the laminate under the condition at 155°C for 45 minutes, whereby a module for a foam test was obtained. A laminate (thickness of 150 $\mu$m) including a polyvinyl fluoride resin film (Tedlar (trademark) manufactured by DuPont), aluminum film, and polyvinyl fluoride film (Tedlar (trademark) manufactured by DuPont) successively laminated in this order was used as the back sheet 22.

Thereafter, the above-mentioned module for the foam test was introduced into an oven at 155°C. The period was recorded, that is from a point after introduction of the module to the oven to a point when expansion of the module is visually recognized because of the gas formation at an interface between the aluminum substrate 25 and the polyethylene terephthalate film 24. The results are shown in Table 1.

[Table 1]

| | | Crosslinker | | | | Period taken by generation of decomposition gas [min] |
|---|---|---|---|---|---|---|
| | | Materials | Activation Energy [kJ/mol] | Content Cp [parts by wt.] | Theoretical Active Oxygen Content Aw [%] | Cp×Aw | |
| Example 1 | 2,5-dimethyl-2,5-di(t-butylperoxy)hexane | 152.0 | 0.6 | 11.02 | 6.61 | 80 |
| Example 2 | di(2-t-butylperoxy-isopropyl)benzene | 166.3 | 0.6 | 9.45 | 5.66 | 100 |
| Example 3 | t-butyl cumyl peroxide | 173.1 | 0.6 | 7.68 | 4.61 | 110 |
| Example 4 | di-t-butyl peroxide | 155.8 | 0.6 | 10.94 | 6.56 | 120 |
| Example 5 | dicumyl peroxide | 158.0 | 0.6 | 5.92 | 3.55 | 65 |
| Comp. Ex. 1 | 1,1-di(t-hexylperoxy)-2-methylcyclohexane | 133.5 | 0.6 | 11.66 | 7.00 | 25 |
| Comp. Ex. 2 | 1,1-di(t-hexylperoxy)-3,3,5-trimethylcyclohexane | 132.1 | 0.6 | 8.92 | 5.35 | 45 |

**Claims**

1. A solar cell sealing film comprising:

   ethylene-vinyl acetate copolymer; and
   a crosslinker; the crosslinker being an organic peroxide having an activation energy of 140 kJ/mol or more, a value obtained by multiplying the content of the organic peroxide based on 100 parts by weight of the ethylene-vinyl acetate copolymer by the theoretical active oxygen content of the organic peroxide being in the range of 3 to 18.

2. The solar cell sealing film as claimed in Claim 1, wherein the organic peroxide is dialkyl peroxide-based organic peroxide.

3. The solar cell sealing film as claimed in Claim 1 or 2, wherein the content of vinyl acetate based on 100 parts by weight of the ethylene-vinyl acetate copolymer is in the range of 20 to 35 parts by weight.

4. The solar cell sealing film as claimed in any of Claims 1 to 3, further comprising a crosslinking auxiliary in an amount of 0.1 to 5.0 parts by weight based on 100 parts by weight of the ethylene-vinyl acetate copolymer.

5. A solar cell comprising:

a transparent front side protection material;

a backside protection material;

a photovoltaic element provided between the transparent front side protection material and the backside protection material;

a sealing film as claimed in any of Claims 1 to 4 which is interposed between the front side protection material and the photovoltaic element and between the backside protection material and the photovoltaic element, the photovoltaic element being sealed by the crosslinkage of the sealing film, and the photovoltaic element, the front side protection material, and the backside protection material being made integral with one another by the sealing film.

FIG. 1

FIG. 2

<table>
<tr><td colspan="2" align="center"><strong>INTERNATIONAL SEARCH REPORT</strong></td><td>International application No.<br>PCT/JP2008/053033</td></tr>
</table>

| | |
|---|---|
| A. CLASSIFICATION OF SUBJECT MATTER<br>*H01L31/04(2006.01)i, C08K5/14(2006.01)i, C08L23/08(2006.01)i*<br><br><br>According to International Patent Classification (IPC) or to both national classification and IPC | |

B. FIELDS SEARCHED

Minimum documentation searched (classification system followed by classification symbols)
*H01L31/04, C08K5/14, C08L23/08*

Documentation searched other than minimum documentation to the extent that such documents are included in the fields searched
      Jitsuyo Shinan Koho          1922-1996   Jitsuyo Shinan Toroku Koho   1996-2008
      Kokai Jitsuyo Shinan Koho    1971-2008   Toroku Jitsuyo Shinan Koho   1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 10-233519 A  (Canon Inc.),<br>02 September, 1998 (02.09.98),<br>Par. Nos. [0017], [0033]<br>& US 6191353 B1          & EP 0784348 A2 | 1-5 |
| X | JP 11-26791 A  (Du Pont-Mitsui Polychemicals Co., Ltd.),<br>29 January, 1999 (29.01.99),<br>Par. Nos. [0011], [0012], [0022]<br>(Family: none) | 1-5 |
| X | JP 2006-303233 A  (Sekisui Chemical Co., Ltd.),<br>02 November, 2006 (02.11.06),<br>Par. No. [0026]; example 2<br>(Family: none) | 1-5 |

☒ Further documents are listed in the continuation of Box C.      ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>   07 March, 2008 (07.03.08) | Date of mailing of the international search report<br>   18 March, 2008 (18.03.08) |
|---|---|
| Name and mailing address of the ISA/<br>   Japanese Patent Office | Authorized officer |
| Facsimile No. | Telephone No. |

Form PCT/ISA/210 (second sheet) (April 2007)

**EP 2 117 049 A1**

<table>
<tr><td colspan="2" align="center"><strong>INTERNATIONAL SEARCH REPORT</strong></td><td>International application No.<br>PCT/JP2008/053033</td></tr>
</table>

C (Continuation).  DOCUMENTS CONSIDERED TO BE RELEVANT

| Category* | Citation of document, with indication, where appropriate, of the relevant passages | Relevant to claim No. |
|---|---|---|
| A | JP 4-311732 A  (Mitsubishi Petrochemical Co., Ltd.),<br>04 November, 1992 (04.11.92),<br>Par. Nos. [0009], [0010]<br>(Family: none) | 1-5 |
| A | JP 2000-164900 A  (Fuji Electric Co., Ltd.),<br>16 June, 2000 (16.06.00),<br>Full text<br>(Family: none) | 1-5 |

Form PCT/ISA/210 (continuation of second sheet) (April 2007)

**EP 2 117 049 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000183385 A